# EUROPEAN PATENT SPECIFICATION

(11) **EP 3 718 930 B1**
(45) Date of publication and mention of the grant of the patent: **02.08.2023**
(21) Application number: 18881765.4
(22) Date of filing: 29.10.2018
(51) Int. Cl.: B65G 1/133, B65G 1/00, H01L 21/677, B65G 1/04, H01L 21/673, G03F 7/20

(54) **STORAGE DEVICE**
SPEICHERVORRICHTUNG
DISPOSITIF DE STOCKAGE

(30) Priority: 27.11.2017 JP 2017226460
(43) Date of publication of application: 07.10.2020
(73) Proprietor: Murata Machinery, Ltd., Kyoto-shi, Kyoto 601-8326 (JP)
(72) Inventor: MIZUTANI, Minoru, Inuyama-shi Aichi 484-8502 (JP); HAYAKAWA, Masafumi, Inuyama-shi Aichi 484-8502 (JP); TOMITA, Hiroyasu, Inuyama-shi Aichi 484-8502 (JP); HAYASHI, Masataka, Inuyama-shi Aichi 484-8502 (JP)
(74) Representative: Jordan, Volker Otto Wilhelm
(86) International application number: PCT/JP2018/040063
(87) International publication number: WO 2019/102795

(56) References cited:
- WO-A1-2013/001930
- CN-A- 106 711 072
- JP-A- 2002 171 698
- JP-A- 2007 165 876
- JP-A- 2011 169 043
- JP-A- 2013 110 805
- US-A- 4 867 629
- US-A- 5 226 713
- US-A- 5 583 408
- US-A1- 2010 292 826
- US-A1- 2010 294 397
- US-A1- 2014 119 856
- US-A1- 2014 124 331

## Description

### Technical field

The present invention relates mainly to a storage apparatus with a rotating shelf.

### Background Art

Conventionally, it is known that a storage apparatus for storing a reticle and the like is used for semiconductor integrated circuit manufacturing. Patent document (PTL) 1 discloses this type of a storage apparatus.

The storage apparatus in PTL 1 includes a housing which forms at least one closed area for storing an object such as wafers or reticles. An object storage apparatus is disposed in the housing. The object storage apparatus has a plurality of annular shelves, which are disposed in parallel in the vertical direction. The object storage apparatus includes means for realizing a rotary motion around a vertical rotation axis. The object storage apparatus comprises a plurality of storage modules. The object storage apparatus is rotated by an electric driving device in such a manner that a respective storage module disposed in the object storage apparatus enters into an arrival position of an object-handling device. An object stored in the storage module is operated by the object-handling device.

### Citation List

Patent Document 1: Japanese Unexamined Pat. App. Pub. No. 2009-545141.

Further prior art is disclosed in the patent documents US4,867,629-A, US5,226,713-A and CN106711072-A.

### Summary of invention

### Technical Problem

For example, it has been demanded to place devices such as various sensors and cameras inside the object storage apparatus for the quality management of the object such as a reticle. With the configuration in PTL 1, however, when electric power is to be supplied to the sensors from an electric power source provided outside the object storage apparatus, twists of the electric power supply cable occur because the object storage apparatus rotates.

The present invention has been made in view of the circumstances described above, and a primary object of the present invention is to provide a storage apparatus allowing that electric power can be supplied to a device disposed on a rotating shelf, while maintaining rotation of the rotating shelf.

### Solution to Problem and Advantageous Effects

Problems to be solved by the present invention are as described above.

Solutions to the problems and advantageous effects thereof will now be described. The scope of the invention is defined by the appended claims.

A first aspect of the present invention provides a storage apparatus configuration for storing an object as follows. The storage apparatus includes a housing, a fixed part, a rotating part and a rotating shaft driving part. The fixed part is disposed in the housing and is fixed its position against the housing. The rotating part is connected to the fixed part through a rotating shaft extending in the vertical direction and rotates relative to the fixed part. The center of the rotation is the rotating shaft. The rotating shaft driving part rotates the rotating shaft. The fixed part includes a power-transmission unit that transmits electric power in a non-contact state. The rotating part includes a rotating shelf, a power drive device and a power-receiving unit. The object is disposed on the rotating shelf. The power drive device is disposed so as to rotate integrally with the rotating shelf and it is driven by electric power. The power-receiving unit supplies the power transmitted from the power-transmission unit to the power drive device.

This enables to realize a wireless power feeding to the power drive device that rotates with the rotating part as required.

It is preferable that the storage apparatus includes the following configuration. That is, the power-transmission unit includes a support and a conductor. The support surrounds at least a part of the outer circumferential of the rotating shaft. The conductor is disposed on the support along the direction in which the support extends. The power-receiving unit includes a coil formed by winding a conductive component. When a magnetic field is generated by a current flowing through the conductor of the power-transmission unit, an induced current is generated in the coil of the power-receiving unit.

In this way, it is possible to realize a wireless power supply with a simple configuration.

In the storage apparatus, the conductor may be formed by a circuit pattern of a printed board.

This makes it possible to provide a low-cost and compact power-transmission unit.

It is possible to provide for the following configuration of the storage apparatus. That is, the support may have a conductor guiding part formed to extend in the circumferential direction. The conductor is disposed along the conductor guiding part.

In this case, the power-transmission unit can be formed with a simple configuration.

In the storage apparatus, it is preferable that the power-transmission unit includes a magnetic sheet provided on a side opposite to a side where the conductor and the power-receiving unit face each other.

This enables, that the magnetic sheet serves as a back yoke, which allows that a magnetic flux resulting for an energized conductor can be concentrated on the side of the power-receiving unit. This enables the power-transmission efficiency of the power-transmission unit to be improved with a compact configuration.

In the storage apparatus, it is preferable that another component is disposed or a gap is formed between the conductor and the magnetic sheet.

This allows to separate the conductor and the magnetic sheet by a distance in a simple manner, so that it is possible to prevent the magnetic flux resulting from the energized conductive material to flow to the side opposite to the power-receiving unit.

In the storage apparatus, it is preferable that a plate member made of a non-magnetic material is disposed between the conductor and the magnetic sheet.

Thus, with a compact configuration, it is possible to effectively reduce the flow of the magnetic flux resulting from the energized conductive material to the side opposite to the power-receiving unit.

It is preferable that the storage apparatus has the following configuration. That is, the storage apparatus includes at least two power-receiving units disposed in a circumferential direction around the rotating shaft. The power-transmission unit is disposed to face a rotation track of the power-receiving unit. When viewed in a direction parallel to the rotating shaft, the power-transmission unit is formed in a circle arc shape having an opening, which extends along a circumferential direction of the rotating shaft and is disposed to always overlap with at least one of the power-receiving units.

In this way, it is possible to realize a miniaturization of the power-transmission unit and a stable wireless power supply.

It is preferable that the storage apparatus has the following configuration. That is, the opening is formed in a size that make it possible to pass the rotating shaft there through. The power-transmission unit is detachably mounted to an outer circumferential side of the rotating shaft.

This enables, that the installation/removal of the power-transmission unit is facilitated, so that the maintenance workability can be improved.

In the storage apparatus, it is preferable that the power drive device includes at least one of a temperature sensor, a humidity sensor, a gas component detector and a camera.

Accordingly, the information related to the storage condition in the rotating shelf using the power drive device can therefore be readily obtained.

### Brief Description of Drawings

[FIG. 1] An external perspective view showing a configuration of a storage apparatus according to a first embodiment of the present invention.
[FIG. 2] A front view of a storage apparatus.
[FIG. 3] A plan view of a storage apparatus.
[FIG. 4] A sectional perspective view showing the details of a reticle storage unit in a housing and a driving configuration for driving the reticle storage unit.
[FIG. 5] A perspective view showing the configuration of a power-transmission unit.
[FIG. 6] A sectional view showing the configuration of the power-transmission unit and a power-receiving unit.
[FIG. 7] A perspective view showing the configuration of the power-receiving unit.
[FIG. 8] A part plan view showing the configuration of a stable wireless power supply.
[FIG.9] A part plan view showing a state that the rotating shelf has rotated from the state of FIG. 8.
[FIG. 10] A part plan view showing the configuration of a wireless power supply in a second embodiment of the present invention.
[FIG. 11] A perspective view showing the configuration of a circuit pattern of a multilayer board in the second embodiment of the present invention.
[FIG. 12] A sectional view showing the configuration of a power-transmission unit and a power-receiving unit in the second embodiment of the present invention.

### Description of Embodiments

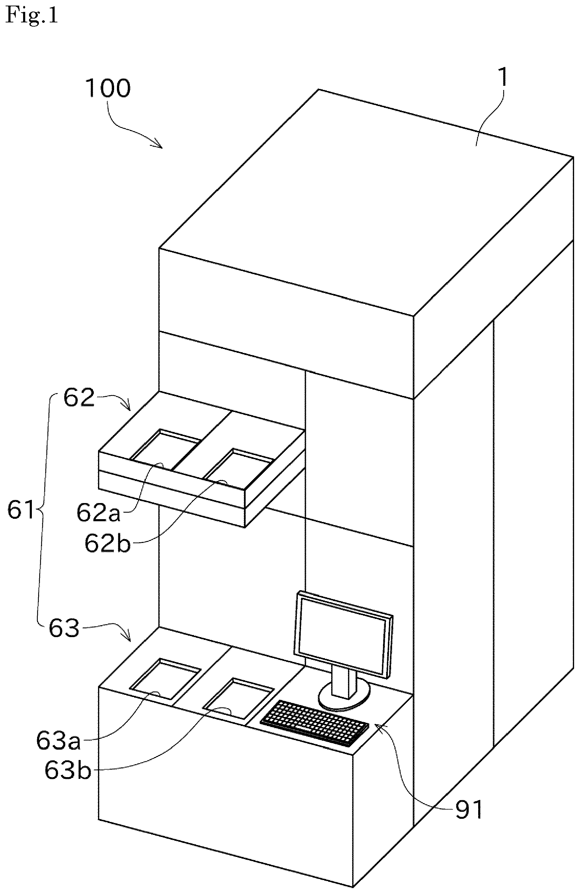

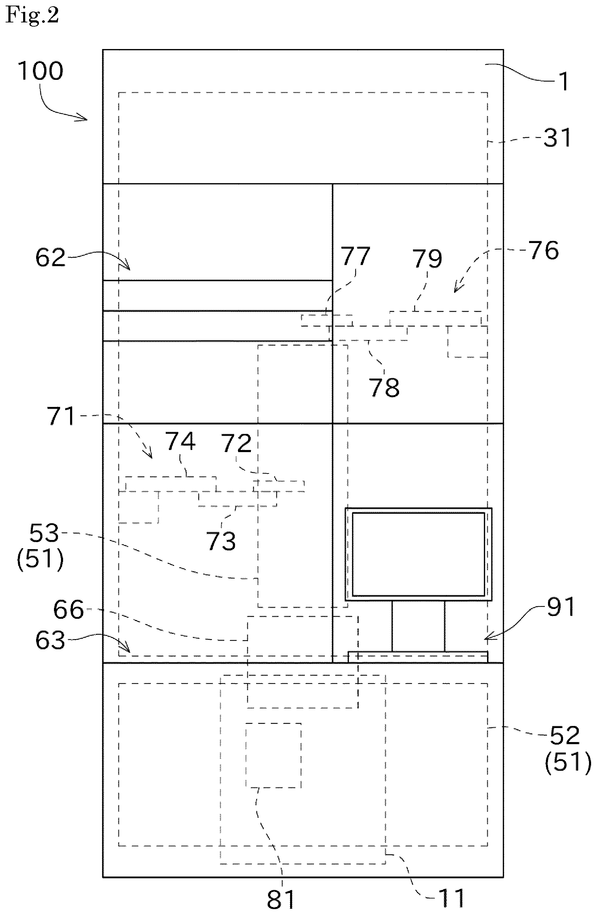

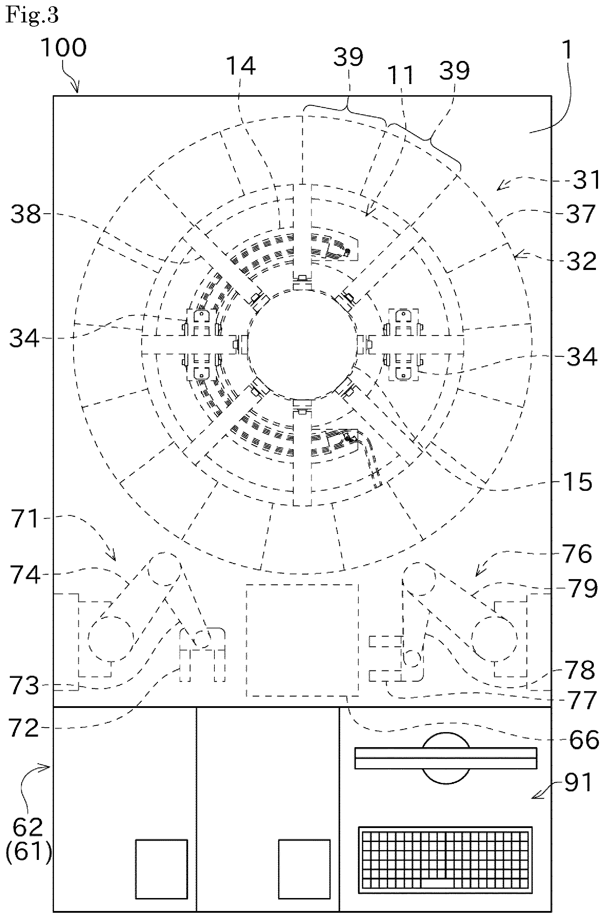

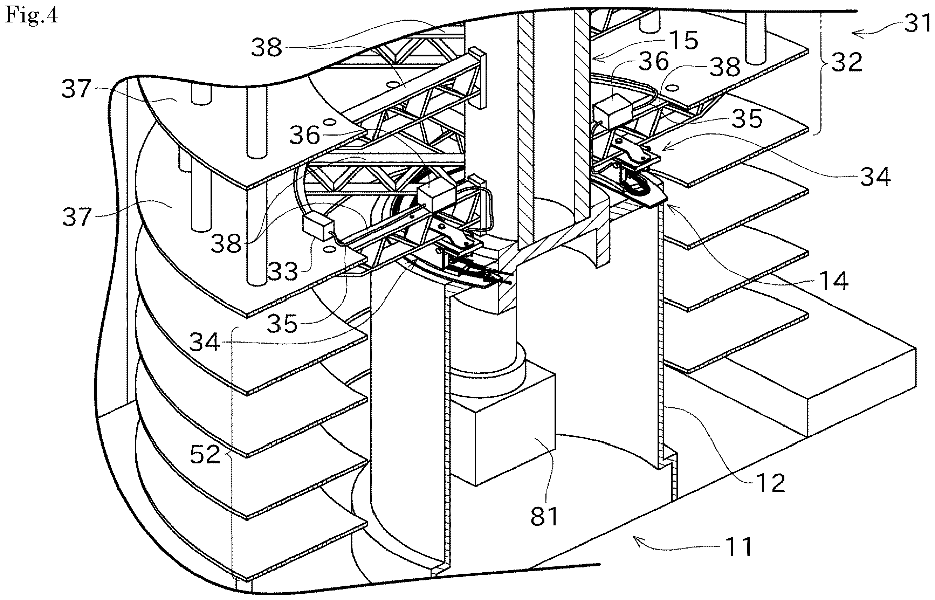

Next, an embodiment of the present invention will now be described with reference to the drawings. FIG. 1 is an external perspective view showing a configuration of a storage apparatus 100 according to an embodiment of the present invention. FIG. 2 is a front view of the storage apparatus 100. FIG. 3 is a plan view of the storage apparatus 100. FIG. 4 is a sectional perspective view showing the details of a reticle storage unit 31 being provided in a housing 1 and a driving configuration for driving the reticle storage unit.

The storage apparatus 100 in a first embodiment as shown in FIG. 1, is placed in a clean room such as of a semiconductor integrated circuit factory or a liquid crystal substrate factory, and is used to store a reticle (tool) for exposure of a semiconductor or a liquid crystal substrate. The storage apparatus 100, as shown in FIG. 1 to FIG. 3 (FIG. 2 and other Figs.), is essentially furnished with the housing 1, a base stand 11, a reticle storage rack 31, a case storage rack 51 and a motor (rotating shaft driving part) 81.

The housing 1, made from a metal plate for example, is formed with a hollow approximately cuboidal shape. Inside the housing 1, a storage space being sealed from the outside is formed.

The storage apparatus 100 includes a purge device (not shown). This purge device can prevent a contamination of reticles housed by filling a purge gas in the storage space inside the housing 1. Without any limitation, the term purge gas may include air or nitrogen gas.

The base stand 11 is disposed at the lower part in the storage space and is fixed in the housing 1, as shown in FIG 2. The base stand 11 includes a support case 12 and a power-transmission unit 14, as shown in FIG.4.

The support case 12 is formed with a hollow cylindrical shape in which its axis is directed along the vertical direction. The support case 12 has a shape, which is closed at its upper end. The rotating shaft 15 extending in the vertical direction is rotatably supported in the center of upper surface of the support case 12 and defines a central axis.

The power-transmission unit 14 is mounted on the upper surface of the support case 12. The power-transmission unit 14 can transmit electric power in a non-contact state to the later-described power-receiving unit 34 mounted in the reticle storage rack 31. Further details of the configuration of the power-transmission unit 14 are described below.

The reticle storage rack 31 stores a large number of reticles. As shown in FIG.4, the reticle storage rack 31 includes a rotating shelf 32, a power driven device, for example a detection device 33, and a power-receiving unit 34. The reticle storage rack 31 is disposed at a position higher than the base stand 11 and is configured to rotate with the rotation of the rotating shaft 15.

The rotating shelf 32 includes a plurality of shelf boards 37 disposed with a gap in the vertical direction. The respective shelf boards 37 are formed in a hollow ring shape. The shelf boards 37 are mounted to the rotating shaft 15 by a plurality of support beams 38 radially fixed to the rotating shaft 15. The support beams 38, for example eight per one shelf board 37, are arranged and are disposed at front and rear positions with equal intervals in the circumferential direction. When the shaft 15 is rotationally driven by the motor 81 described below, then the plurality of shelf boards 37 rotate simultaneously. Accordingly, the rotation phase can be changed so that the rotating shelf 32 is oriented in a desired direction. The rotating shaft 15 can rotate in normal and reverse directions.

As shown in FIG. 3, a plurality of storage areas 39 are defined such that the storage space on the upper side of the respective shelf boards 37 is divided into a plurality of storage areas in the circumferential direction. Although not shown, in the respective storage areas 39, a reticle storage module formed in a hollow box shape is placed on the shelf board 37. Reticles are stored vertically aligned within the reticle storage module. It is possible to freely move the respective reticles in or out from the reticle storage module, as necessary.

By appropriate rotating the rotating shelf 32, the position of the shelf board 37 and therewith the rotation phase of the storage area 39 where the specific reticle storage module is disposed can be adjusted so as to align the accessible rotation phase with a reticle transport device 76 described below. Under these conditions, using the reticle transport device 76, a desired reticle can be freely pulled out or put in the reticle storage module.

The detection device 33 shown in FIG. 4, for example, is fixed to the shelf board 37, and can acquire the information related to a storage state such as a temperature and a humidity in the reticle storage shelf 31 and a position of the reticle storage module. Examples of the detection device 33 include a known temperature sensor, a humidity sensor, a camera, a gas component detector and the like, however, without being limited to these elements. The position and number of the detection device or devices 33 disposed on the rotating shelf 32 can be arbitrarily determined depending on the circumstances. The detection device 33 rotates integrally with the rotating shelf 32 if the rotating shelf 32 rotates. The detection device 33 is driven by the electric power supplied from the power-receiving unit 34 through a cable 35.

The detection device 33 transmits the detected information to an apparatus and the like (for example, the terminal device 91 shown in FIG. 1) disposed outside of the storage apparatus 100 by wireless communication. The wireless communication may be implemented according to a known standard such as a wireless LAN for example. This configuration allows the administrator of the storage apparatus device 100 to easily determine the storage state of the reticle storage shelf 31 from the outside on the display or the like of the terminal device 91.

As shown in FIG. 4, the power-receiving unit 34 is mounted to a support beam 38 supporting a lowermost shelf board 37 belonging to the rotating shelf 32, such that the power-receiving unit points in a downward direction. The power-receiving unit 34 obtains wirelessly electric power from the power-transmission unit 14 and then supplies the electric power to the detection device 33 through the cable 35.

As shown in FIG. 2, the case storage rack 51 includes a storage shelf 52 and a buffer shelf 53. The storage shelf 52 and the buffer shelf 53 may serve to store a transport case (not shown) used to convey the reticle. The storage shelf 52 is formed with a cylindrical shape as a whole, and is disposed below the reticle storage shelf 31, as shown in FIG.4. This storage shelf 52 includes a plurality of shelf boards disposed in the vertical direction, and these shelf boards will rotate by a motor (not shown). As shown in FIG.2, the buffer shelf 53 is fixed immediately above a case opening device 66 described below. This buffer shelf 53 is used for the purpose of temporarily storing a transport case waiting for processing in the case opening device 66, for example.

For example, the motor 81 is provided in the form of an electric motor, and is fixed inside the support case 12. The electric power for driving the motor 81 is supplied from the electric power source (not shown) using a cable. The driving force of the motor 81 is transmitted to the rotating shaft 15 by an appropriate driving transmission mechanism, so that the rotating shaft 15 is driven.

The storage apparatus 100 includes a delivery port 61, the case opening device 66, a case transport device 71 and the reticle transport device 76, in addition to the housing 1, the reticle storage rack 31 and the case storage rack 51

As shown in FIG. 1, the delivery port 61 includes an upper port 62 and a lower port 63.

The upper port 62 is disposed somewhat upward in the front of the housing 1. The upper port 62 has two openings 62a and 62b of which the upper surfaces are capable of opening. A transfer case holding a reticle can be delivered through the openings 62a and 62b to the storage apparatus 100 by an overhead transfer vehicle (not shown).

The lower port 63 is disposed lower than the upper port 62 in the front of the housing 1. The lower port 63 has two openings 63a and 63b of which the upper surfaces are capable of opening. A transfer case holding a reticle can be delivered through the openings 63a and 63b to the storage apparatus 100 by an operator or a robot and the like.

The transport case transported to the delivery port 61 will be transported by the case transport device 71 to the case opening device 66 or the case storage shelf 51.

The case opening device 66 is disposed in the above storage space, which achieves a state where the internal reticle can be taken out after opening the transport case.

As shown in FIG. 3, the case transport device 71 is disposed on the side close to the delivery port 61 in the storage space. The case transport device 71 is composed as an articulated arm robot includes a hand 72 and two arms 73 and 74 and the like. Furthermore, the case transport device 71 can move in the vertical direction driven by a motor (not shown).

The case transport device 71 can transported the transport case between the upper port 62 or the lower port 63, the case opening device 66, and the case storage rack 51, by operating the hand 72 and the arms 73 and 74 while rising and falling as needed.

As shown in FIG. 3, the reticle transport device 76 is disposed in the above-storage space at a position facing the case transport device 71, with the case opening device 66 interposed there between in planar view. As with the case transport device 71, the reticle transport device 76 is composed as an articulated arm robot includes a hand 77 and two arms 78 and 79. Furthermore, the reticle transport device 76 can move in the vertical direction driven by a motor (not shown).

The reticle transport device 76 can transport a reticle between the case opening device 66 and the reticle storage shelf 31, by operating the hand 77 and the arms 78 and 79 while rising and falling as needed.

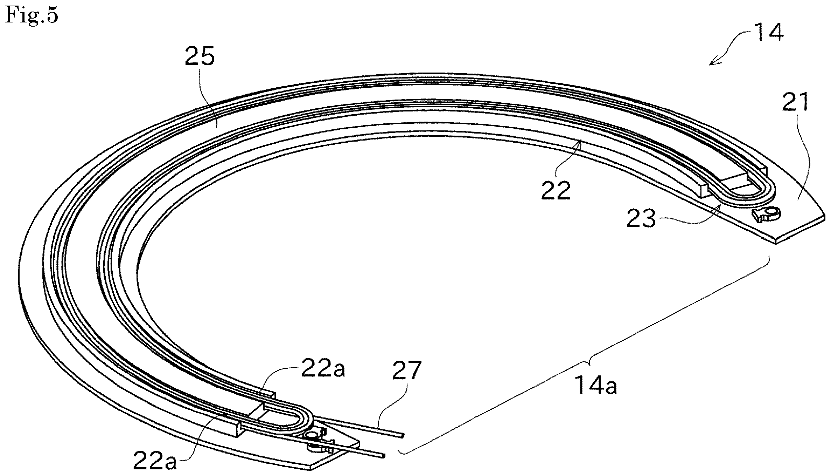

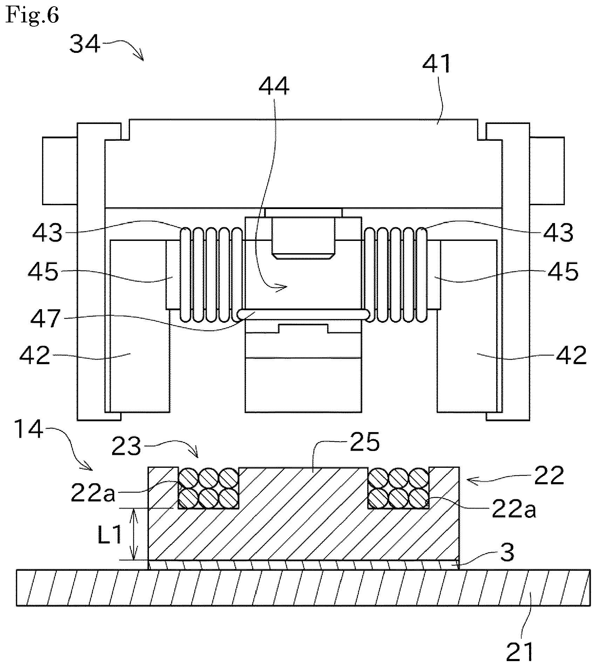

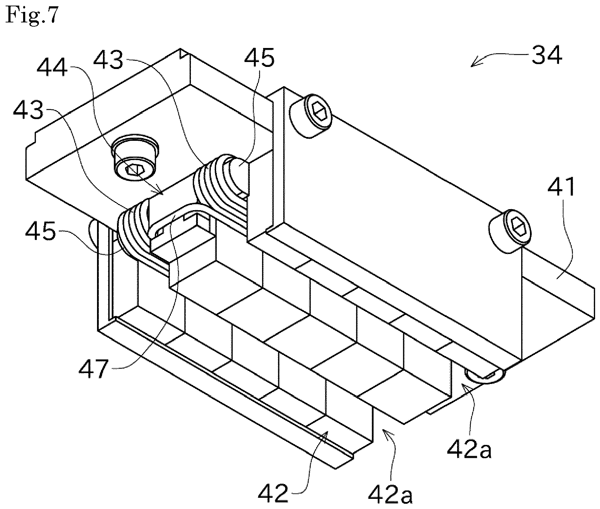

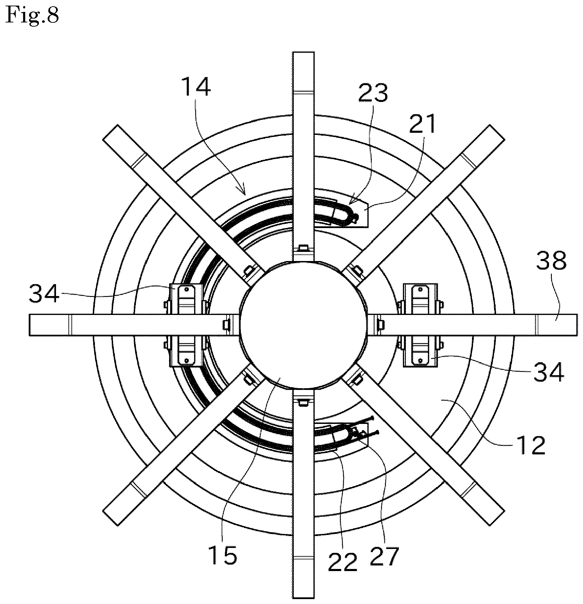

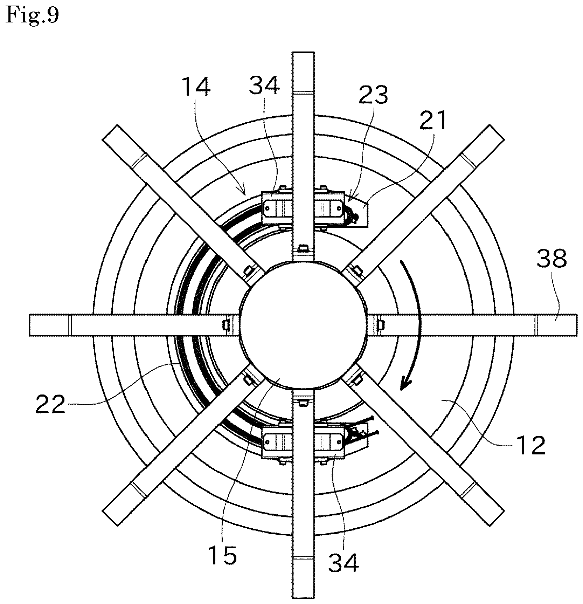

To continue, a wireless power supply structure for supplying electric power to the detection device 33 disposed on the reticle storage shelf 31 is described in detail with reference to FIGS. 4 to 9. FIG. 5 is a perspective view showing the configuration of the power-transmission unit 14. FIG. 6 is a sectional view showing the configuration of the power-transmission unit 14 and the power-receiving unit 34. FIG. 7 is a perspective view showing the configuration of the power-receiving unit 34. FIG. 8 is a part plan view showing the configuration of the wireless power supply. FIG. 9 is part plan view showing a state that the rotating shelf 32 has rotated from the state of FIG. 8. Moreover, FIGS. 8 and 9 shows a state in which the shelf board 37 is removed from the rotating shelf 32.

As shown in FIG. 4, the wireless power supply structure includes the power-transmission unit 14 mounted on an upper portion of the support case 12 in the base stand 11 and a plurality of (two power-receiving units 34 in the embodiment) power-receiving units 34 mounted to the lowermost support beams 38 in the reticle storage rack 31.

As shown in FIGS. 4 and 5, the power-transmission unit 14 is formed in a circle arc shape having an opening 14a and extending along a circumferential direction with respect to the rotating shaft 15. The power-transmission unit 14 has a base plate (base member) 21, a winding support block (support) 22 and a primary coil 23. Although not shown in FIGS. 4 and 5, as shown in FIG. 6, the power-transmission unit 14 further has a magnetic sheet 3.

For example, the base plate 21 is formed as a slender plate which is approximately circle arc shaped and made of a non-magnetic material such as aluminum metal. The base plate 21 is formed into a thin plate having a thickness of about several mm and the like. The base plate 21 is detachably mounted to the upper surface of the support case 12 by fixing members (for example, screws) not shown.

A winding support block 22 is formed as a slender plate which is approximately circle arc shaped, as is the case for the base plate 21, and is fixed to an upper surface of the magnetic sheet 3 described below. For example, the winding support block 22 is formed by injection molding of a synthetic resin. As shown in FIG. 5, in the upper surface of the winding support block 22, two rail portions 22a formed thin and long in the circumferential direction are formed.

The respective rail portions 22a are composed as a mortise groove whose upper side (near the power-receiving unit 34) is open and which is formed over the whole circumferential direction of the winding support block 22 formed in the circle arc shape. A primary coil 23 can be accommodated in the mortise groove. The two rail portions 22a are disposed in a concentric circle arc shape. As a result, a relatively convex arc-shaped convex portion (conductor guiding part) 25 is provided between the inner circumferential side rail portion 22a and the outer circumferential side rail portion 22a in the upper surface of the winding support block 22.

The primary coil 23 is formed by winding a slender litz wire (conductor) 27 as a good conductor of electricity along the rail portion 22a. Specifically, as shown in FIG. 5, after disposing the litz wire 27 toward the other end side from one end side in the circumferential direction of the winding support block 22 along the single rail portion 22a, it is folded at the other end side to be disposed along the other rail portion 22a, and is then folded back again at the one end side. In this manner, the primary coil 23 is being formed by revolving plural times the litz wire 27 about the convex portion 25 while alternately providing the litz wire 27 on the two rail portions 22a. In the primary coil 23, an alternating current can flow from an inverter (not shown).

In the present embodiment, the litz wire 27 is wound so that a plurality of layers in the vertical direction are formed and the litz wire revolves plural times about the convex portion 25 in each layer. This enables, that a strong magnetic flux can be generated with a compact configuration.

The opening 14a is formed with a size that make it possible to pass the rotating shaft 15 there through. In detail, the distance between both ends of the base plate 21 is formed so as to be substantially equal to the diameter of the rotating shaft 15. Thereby, the rotating shaft 15 is capable of being inserted into or out of the power-transmission unit 14 through the opening 14a. Consequently, attaching/detaching of the power-transmission unit 14 is facilitated which leads to improved maintainability. Moreover, it is easy to mount the power-transmission unit 14 for retrofitting to an existing storage apparatus.

The magnetic sheet 3 is formed as a slender sheet, which is approximately circle arc shaped as is the case with the base plate 21, and is fixed to an upper surface of the base plate 21. The magnetic sheet 3 is made of an appropriate magnetic material and is formed in a thin sheet shape. The thickness of the magnetic sheet 3 can be 1 mm or less for example.

As shown in FIG 6, the magnetic sheet 3 is provided below the winding support block 22 and above the base plate 21 to be interposed between the primary coil 23 and the base plate 21.

The magnetic sheet 3 provided as above serves as a back yoke and allows to prevent the magnetic flux generated in the energized primary coil 23 from leaking downward, thereby concentrating the magnetic flux upward. As a result, a strong magnetic field can be generated on the power-receiving unit 34 side. In addition, the effect that the magnetic flux is intercepted by the magnetic sheet 3 can prevent the generation of eddy currents in the base plate 21. Thus, the eddy current loss in the base plate 21 is suppressed, and the power transmission efficiency of the power-transmission unit 14 can be improved.

The winding support block 22 (specifically, a portion corresponding to the bottom of the rail portion 22a) is disposed between the primary coil 23 and the magnetic sheet 3. It is preferable that the portion is formed to have a certain thickness. As shown in FIG. 6, it is considered that the length L1 from the inner base surface of the rail portion 22a to the base surface of the winding support block 22 may be several mm for example. Only the length L1 is disposed between the primary coil 23 and the magnetic sheet 3.

As shown in FIG. 7 as a perspective view seen from below, the power-receiving unit 34 includes a base block (base member) 41, a magnetic core 42 and a secondary coil 43.

The base block 41 is formed of a resin and the like. The magnetic core 42 is made of a ferrite core and the like, and is fixed at the lower part of the base block 41. The magnetic core 42 is formed as a horizontally positioned E-shape, and in a base surface thereof, two mortise grooves 42a having a linear shape and being opened downward are formed. The secondary coil 43 is formed by winding an electric wire (conductive component) 47 around the above-described magnetic core 42.

A winding guide member 44 is fixed to the base surface of the base block 41. As shown in FIG. 7, although only one winding guide member 44 is shown, two winding guide members 44 are disposed at both ends of the magnetic core 42 in the longitudinal direction of the mortise grooves 42a, respectively. Each winding guide member 44 has a turn guide 45. An electric wire 47 forming the secondary coil 43 is wound around the turn guides 45.

The secondary coil 43 is disposed corresponding to the respective mortise grooves 42a. Namely, as shown in FIG. 7, the secondary coil 43 is formed by winding the electric wire 47 around the mortise grooves 42a in the magnetic core 42.

With the above configuration, when an alternating current flows through the primary coil 23 of the power-transmission unit 14, in the power-receiving unit 34 facing the power-transmission unit 14 in vertical direction, an induced current will flow in the secondary coil 43. Under these conditions, it is possible to supply electric power to the power-receiving unit 34 in a non-contact state from the power-transmission unit 14.

In the wireless power supply structure in the present embodiment, as shown in FIG. 8, the power-transmission unit 14 is fixed to the upper surface of the support case 12 so as to surround the outer circumference of the rotating shaft 15. On the other hand, the two power-receiving units 34 are disposed at positions corresponding to rotation phases differing from each other by 180 ° about the rotating shaft 15, and their longitudinal directions are arranged such as to be parallel to the tangential direction of the primary coil 23 of the power-transmission unit 14. In other words, a rotation locus of the power-receiving units 34 forms a circle. The power-receiving units 34 are mounted oriented in the downward direction to the support beam 38 of the reticle storage rack 3 1.

The power-transmission unit 14 is formed in a circle arc shape, and its central angle defines an angle slightly larger than 180 °. Accordingly, the large opening 14a that make it possible to pass the rotating shaft 15 is formed in the power-transmission unit 14. In addition, as shown in FIGS. 8 and 9, although the opening 14a is formed in the power-transmission unit 14 as described above, the power-transmission unit 14 can always transmit electric power since it faces always at least one of the power-receiving units 34 in the vertical direction. In this condition, regardless of the rotation phase of the rotating shelf 32, a stable wireless power supply can be realized.

The detection device 33 shown in FIG. 4 is electrically connected to both two power-receiving units 34 by a cable 35. Furthermore, the alternating current outputted from the power-receiving unit 34 is converted into a direct current by a rectifier 36. The rectifier 36 is mounted to rotate with the rotating shaft 15. Although FIG. 4 shows an example in which the rectifier 36 is mounted to the support beam 38, the position of the rectifier 36 can be changed as appropriate. As a result, electric power can be supplied to detection device 33 from any one of the power-receiving units 34. As described above, since the wireless power supply structure is disposed between the base stand 11 and the rotating shelf 32 that relatively rotated to each other, no electric wire is twisted, even if the rotating shelf 32 rotates, and a stable electric power can be supplied to the detection device 33.

As described above, the storage apparatus 100 of the present embodiment includes the housing 1, the base stand 11, the reticle storage rack 31 and the motor 81. The base stand 11 is disposed in the housing 1 and is fixed its position against the housing. The reticle storage rack 31 is connected to the fixed part through the rotating shaft 15 extending in the vertical direction 15 and rotates relatively to the base stand 11, the rotation center being the rotating shaft 15. The motor 81 rotates the rotating shaft 15. The base stand 11 includes a power-transmission unit 14 that transmits electric power in non-contact state. The reticle storage rack 31 includes the rotating shelf 32, the detection device 33 and the power-receiving unit 34. A reticle is disposed on the rotating shelf 32. The detection device 33 is disposed so as to rotate integrally with the rotating shelf 32 and is driven by electric power. The power-receiving unit 34 supplies the electric power transmitted from the power-transmission unit 14 to the detection device 33.

This enables, to realize a wireless power feeding to the detection device 33 disposed on the rotating reticle storage rack 31.

Further, in the storage apparatus 100 of the present embodiment, the power-transmission unit 14 includes the winding support block 22 and the litz wire 27. The winding support block 22 surrounds parts of the outer peripheries of the rotating shaft 15. The litz wire 27 is disposed on the winding support block 22 along the direction in which the winding support block 22 extends. The power-receiving unit 34 includes the secondary coil 43 formed by winding the electric wire 47. When a magnetic field generated by a current flowing through the litz wire 27 of the power-transmission unit 14, an induced current is generated in the secondary coil 43 of the power-receiving unit 34.

In this way, it is possible to realize a wireless power supply with a simple configuration.

Further, in the storage apparatus 100 of the present embodiment, the winding support block 22 having a convex portion 25 is formed to extend in the circumferential direction. The litz wire 27 is disposed along the convex portion 25.

In this way, the power-transmission unit 14 can be realized with a simple configuration.

In addition, in the storage apparatus 100 of the present embodiment, the power-transmission unit 14 includes the magnetic sheet 3 provided on the side opposite to the side where the litz wire 27 and the power-receiving unit 34 face each other.

This enables, that the magnetic sheet serves as a back yoke, which allows that an energized magnetic flux caused by energizing the litz wire 27 is concentrated on the side of the power-receiving unit 34. This enables with a compact configuration an improvement of the power-transmission efficiency of the power-transmission unit 14.

Furthermore, in the storage apparatus 100 of the present embodiment, the winding support block 22 is another member, which is disposed between the litz wire 27 and the magnetic sheet 3.

This allows that the litz wire 27 and the magnetic sheet 3 can be simply separated by a distance, so that it is possible to prevent the magnetic flux resulting from energizing the litz wire 27 to flow to the side opposite to the power-receiving unit 34.

Further, the storage apparatus 100 of the present embodiment includes the two power-receiving units 34 disposed on the circumference around the rotating shaft 15. The power-transmission unit 14 is disposed to face the rotation track of the power-receiving units 34.When viewed in a direction parallel to the rotating shaft 15, the power-transmission unit 14 is formed in a circle arc shape having the opening 14a and which extends along a circumferential direction of the rotating shaft 15, and is disposed to always overlap with at least one of the power-receiving units 34.

In this way, it is possible to realize miniaturization of a power-transmission unit 14 and a stable wireless power supply.

Furthermore, in the storage apparatus 100 of the present embodiment, the opening 14a in the power-transmission unit 14 is formed in a size that make it possible to pass the rotating shaft 15 there through. The power-transmission unit 14 is detachably mounted to an outer circumferential side of the rotating shaft 15.

Consequently, attaching/detaching of the power-transmission unit 14 is facilitated and leads to improvements to the maintenance work.

Further, in the storage apparatus 100 of the present embodiment, the detection device 33 can be provided as a temperature sensor, a humidity sensor or a camera and the like.

Thereby, it is possible to readily obtain the information related to the storage condition and the like in the rotating shelf 32 using the detection device 33.

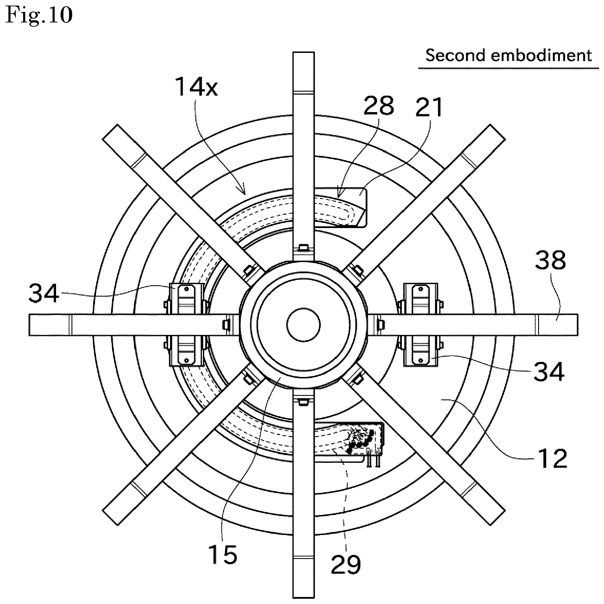

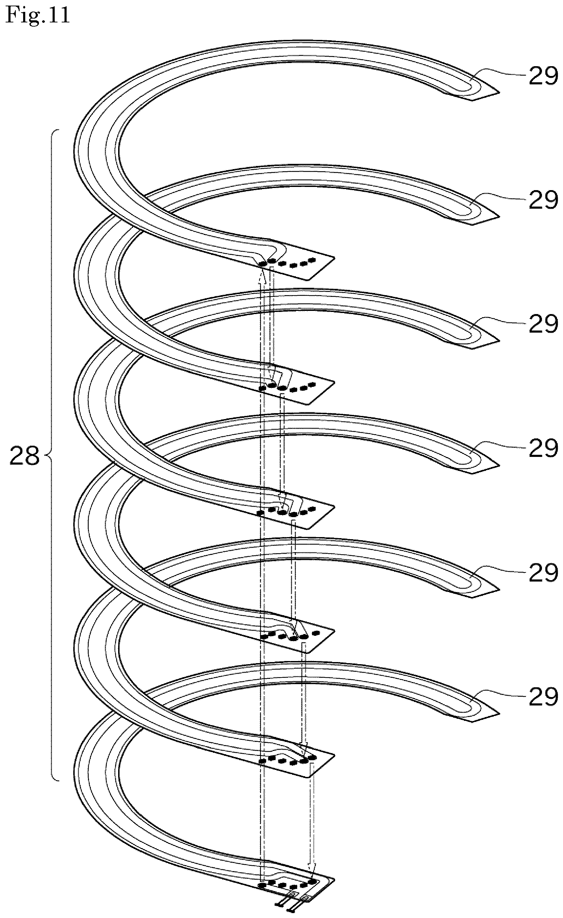

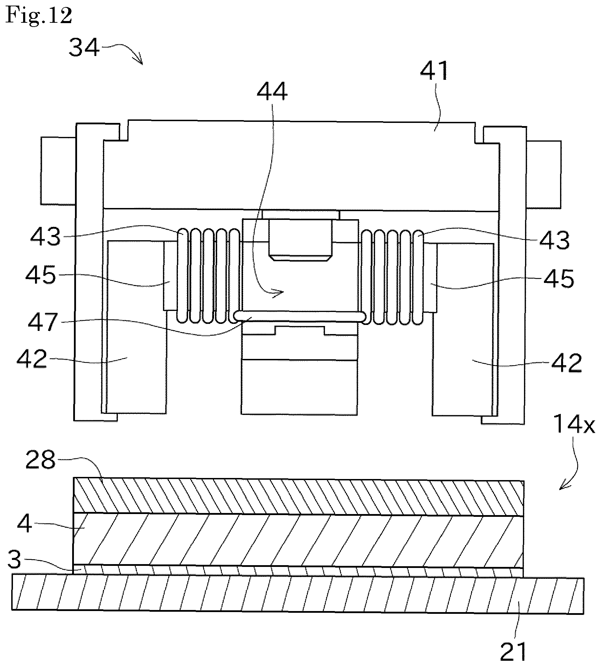

Next, a second embodiment will be described. FIG. 10 is a part plan view showing the configuration of the wireless power supply having a power-transmission unit 14x of the second embodiment. FIG. 11 is a perspective view showing the configuration of the circuit pattern 29 as a multilayer board 28 of the second embodiment of the present invention. FIG. 12 is a side perspective view showing a configuration of the power-transmission unit 14x and power-receiving unit 34 of the second embodiment. Further, in the description of the present embodiment, members that are the identical or similar as those of the above-described embodiment are given the same reference numerals in the figures, and a description thereof can be omitted.

As shown in FIG. 10, the power-transmission unit 14x of the present embodiment includes the base plate 21, the magnetic sheet 3, the multilayer board (printed board) 28 and a resin plate (plate member) 4. Specifically, in the multilayer board 28, a board made of for example glass fiber corresponds to a support, and a circuit pattern 29 formed of for example copper foil provided on the surface of that substrate corresponds to a conductor.

The multilayer board 28 is disposed on the resin plate 4 provided on the magnetic sheet 3. In the present embodiment, the multilayer board 28 is composed as a six-layer board, and the circuit pattern 29 of each layer is formed in slender loop shape that reciprocates along an arc shape of the outer shape of the multilayer board 28 as shown in FIG 11. The circuit pattern 29 of each layer is electrically connected to the upper side or lower side of the circuit pattern 29 via a through hole. This enables, that a six-turn primary coil is formed.

As shown in FIG. 12, the resin plate 4 is provided below the multilayer board 28 and above the base plate 21 to be interposed between the multilayer board 28 and the magnetic sheet 3. The resin plate 4 is made of a resin of non-magnetic material with a low magnetic permeability. This resin is a non-conductive material. The resin plate 4 has a predetermined thickness and is formed in a plate shape having the same shape as the multilayer board 28 in a planar view. The magnetic sheet 3 is disposed on one side of the resin plate 4 in the thickness direction, and the multilayer board 28 is disposed on the other side. It is considered that the thickness of the resin plate 4 may be several mm for example.

In this way, in the present embodiment, the power-transmission unit 14x having the same function as the first embodiment can be configured by a printed circuit board, which makes is possible to realize a cost reduction and a compact configuration.

Further, in the present embodiment, since the resin plate 4 is disposed between the multilayer board 28 and the magnetic sheet 3, it is possible to avoid that the magnetic flux generated by the circuit pattern 29 flows to the side opposite to the power-receiving unit 34 with a compact configuration. Thereby, the hysteresis loss in the magnetic sheet 3 and the eddy current loss in the base plate 21 are suppressed and therewith the power-transmission efficiency can be improved.

While a preferred embodiment and variations of the present invention have been described above, the above configurations may be modified, for example, as follows.

Although the reticle storage rack 31 is configured to rotate integrally as a whole, the invention is not limited to this realization. For example, the reticle rack 31 may be configured that every shelf board 37 rotates individually. In this case, the above wireless power supply structure may be disposed between the respective shelf boards 37.

In the winding support block 22, the configuration may be such that the mortise groove-shaped rail portion 22a is omitted and the convex portion 25 may be changed to a simple configuration in which a convex shape is formed. In that case, the primary coil 23 is formed by disposing (wrapping) the litz wire 27 along the convex portion 25.

In the power-transmission unit 14, the litz wire 27 may be disposed to reciprocate along the winding support block 22 while turning the litz wire only once instead of turning a plurality of times around. This configuration may be interpreted as forming the primary coil 23 which has a single winding.

The number of windings of the primary coil 23 in the power-transmission unit 14 and secondary coil 43 in the power-reception unit 34 can be appropriately changed, respectively.

The detection device 33 can be fixed to, for example, the support beam 38 of an appropriate portion of the rotating shelf 32.

Also, a battery capable of temporarily storing electric power may be provided to the reticle storage rack 31. In this case, the electric power is to be supplied from the battery to the detection device 33 by charging the battery with the power supplied from the power-receiving unit 34.

The power-transmission units 14 and 14x may be formed in a closed circular-shape without the opening 14a. In that case, the number of the power-receiving units 34 may be one.

The power-transmission unit 14 and the power-receiving unit 34 may be changed to a configuration in which they face each other in the radial direction instead of the configuration facing each other in the axial direction of the rotating shaft 15.

In the power-transmission unit 14, the resin plate 4 may be provided between the winding support block 22 and the magnetic sheet 3. In this case, the winding support block 22 may be thinly formed.

For example, by using a small spacer, the winding support block 22 or the multilayer board 28 may be disposed upward from the magnetic sheet 3 to form a gap therebetween.

At least one of the magnetic sheet 3 and the resin plate 4 may be omitted.

It is possible to also supply an electric power to a power drive device not being a detection device 33 thorough the above power-transmission unit 14 and power-reception unit 34.

Also, the storage apparatus 100 can be used to store objects not being a reticle, for example, semiconductor integrated circuit wafer.

### Reference Signs List

1 housing
4 resin plate (plate member)
11 base stand
12 support case
14, 14x power-transmission unit
14a opening
15 rotating shaft
21 base plate (base member)
22 winding support block (support)
22a two rail portions
23 primary coil
25 convex portion
27 litz wire
28 multilayer board
29 circuit pattern
31 reticle storage rack
32 rotating shelf
33 detection device (power driven device)
34 power-receiving unit
35 cable
36 rectifier
37 shelf board
38 support beam
41 base block
42 magnetic core
42a mortise groove
43 secondary coil
44 winding guide member
45 turn guide
47 electric wire
51 case storage rack
52 storage shelf
53 buffer shelf
61 delivery port
62 upper port
62a, 62b opening
63 lower port
63a, 63b opening
66 case opening device
71 case transport device
72 hand
73, 74 arm
76 reticle transport device
77 hand
78, 79 arm
81 motor
91 terminal device
100 storage apparatus

## Claims

1. A storage apparatus (100) which stores objects, comprising:
a housing (1);
a base stand (11) being disposed in the housing (1) and its position being fixed against the housing (1);
a rotating storage rack (31) which is connected to the base stand (11) through a rotating shaft (15) extending in the vertical direction and rotating relative to the base stand (11), the center of rotation being the rotating shaft (15), the rotating storage rack (31) comprising a rotating shelf (32) on which objects are disposed; and
a rotating shaft driving part (81) which rotates the rotating shaft (15);
wherein
the base stand (11) comprises a power-transmission unit (14) which transmits electric power in a non-contact state between the base stand (11) and the storage rack (31); and
the rotating storage rack (31) comprises:
a power driven device (33) or a detection device (33), the device being disposed so as to rotate integrally with the rotating shelf (32) and the device being driven by electric power; and
a power-receiving unit (34) which supplies the electric power transmitted from the power-transmission unit (14) to the power driven device (33) or the detection device (33).

2. The storage apparatus (100) according to claim 1, wherein
the power-transmission unit (14) includes:
a support (22) which surrounds at least a part of the outer circumferential of the rotating shaft (15), and
a conductor (27) disposed on the support (22) along the direction in which the support (22) extends,
wherein the power-receiving unit (34) comprises a coil (43) formed by winding a conductive component (47), and
when a magnetic field is generated by a current flowing through the conductor (27) of the power-transmission unit (14), an induced current is generated in the coil (43) of the power-receiving unit (34).

3. The storage apparatus (100) according to claim 2, wherein
the conductor (27) is provided by a circuit pattern (29) of a printed board (28).

4. The storage apparatus (100) according to claim 2, wherein
the support (22) has a conductor guiding part (25) formed to extend in the circumferential direction, and
the conductor (27) is disposed along the conductor guiding part (25).

5. The storage apparatus (100) according to any one of claims 2 to 4, wherein
the power-transmission unit (14) has a magnetic sheet (3) provided on a side opposite to a side where the conductor (27) and the power-receiving unit (34) face each other.

6. The storage apparatus (100) according to claim 5, wherein
another component is disposed or a gap is formed between the conductor (27) and the magnetic sheet (3).

7. The storage apparatus (100) according to claim 6, wherein
a plate member (4) made of a non-magnetic material is disposed between the conductor (27) and the magnetic sheet (3).

8. The storage apparatus (100) according to any one of claims 1 to 7 comprising:
at least two power-receiving units (34) disposed in a circumferential direction around the rotating shaft (15), wherein
the power-transmission unit (14) is disposed to face a rotation track of the power-receiving units (34), and
when viewed in a direction parallel to the rotating shaft (15), the power-transmission unit (14) is formed in a circle arc shape having an opening (14a) which extends along a circumferential direction of the rotating shaft (15), wherein the power-transmission unit (14) is disposed to always overlap with at least one of the power-receiving units (34).

9. The storage apparatus (100) according to claim 8, wherein
the opening (14a) is formed in a size that make it possible to pass the rotating shaft (15) there through, and
the power-transmission unit (14) is detachably mounted to an outer circumferential side of the rotating shaft (15).

10. The storage apparatus (100) according to any one of claims 1 to 9, wherein
the power driven device (33) includes at least one of a temperature sensor, a humidity sensor, a gas component detector and a camera.

## Patentansprüche

1. Speichervorrichtung (100), welche Objekte speichert, umfassend:
ein Gehäuse (1);
einen Basisständer (11), welcher in dem Gehäuse (1) angeordnet ist und dessen Position gegenüber dem Gehäuse (1) fixiert ist;
ein rotierendes Speichergestell (31), welches über eine rotierende Welle (15), welche sich in der vertikalen Richtung erstreckt und relativ zu dem Basisständer (11) rotiert, mit dem Basisständer (11) verbunden ist, wobei der Rotationsmittelpunkt die rotierende Welle (15) ist, wobei das rotierende Speichergestell (31) ein rotierendes Regal (32) umfasst, auf welchem Objekte angeordnet sind; und
einen Antriebsteil (81) einer rotierenden Welle, welcher die rotierende Welle (15) rotiert;
wobei der Basisständer (11) eine Leistungsübertragungseinheit (14) umfasst, welche elektrische Leistung in einem kontaktlosen Zustand zwischen dem Basisständer (11) und dem Speichergestell (31) überträgt; und
wobei das rotierende Speichergestellt (31) umfasst:
eine leistungsgetriebene Vorrichtung (33) oder eine Detektionsvorrichtung (33), wobei die Vorrichtung derart angeordnet ist, dass sie integral mit dem rotierenden Regal (32) rotiert und die Vorrichtung durch elektrische Leistung angetrieben wird; und
eine Leistungsaufnahmeeinheit (34), welche die elektrische Leistung, welche von der Leistungsübertragungseinheit (14) übertragen wird, an die leistungsgetriebene Vorrichtung (33) oder die Detektionsvorrichtung (33) liefert.

2. Speichervorrichtung (100) nach Anspruch 1, wobei:
die Leistungsübertragungseinheit (14) umfasst:
eine Halterung (22), welche wenigstens einen Teil des äußeren Umfangs der rotierenden Welle (15) umgibt, und
einen Leiter (27), welcher an der Halterung (22) entlang der Richtung angeordnet ist, in welcher sich die Halterung (22) erstreckt,
wobei die Leistungsaufnahmeeinheit (34) eine Spule (43) umfasst, welche durch Wickeln einer leitfähigen Komponente (47) gebildet ist, und
wenn ein Magnetfeld durch einen Strom erzeugt wird, welcher durch den Leiter (27) der Leistungsübertragungseinheit (14) fließt, ein induzierter Strom in der Spule (43) der Leistungsaufnahmeeinheit (34) erzeugt wird.

3. Speichervorrichtung (100) nach Anspruch 2, wobei
der Leiter (27) durch ein Schaltungsmuster (29) einer Leiterplatte (28) bereitgestellt ist.

4. Speichervorrichtung (100) nach Anspruch 2, wobei
die Halterung (22) einen Leiterführungsteil (25) aufweist, welcher derart gebildet ist, dass er sich in der Umfangsrichtung erstreckt, und
der Leiter (27) entlang des Leiterführungsteils (25) angeordnet ist.

5. Speichervorrichtung (100) nach einem der Ansprüche 2 bis 4, wobei
die Leistungsübertragungseinheit (14) eine Magnetbahn (3) aufweist, welche an einer Seite bereitgestellt ist, welche einer Seite entgegengesetzt ist, an welcher der Leiter (27) und die Leistungsaufnahmeeinheit (34) einander zugewandt sind.

6. Speichervorrichtung (100) nach Anspruch 5, wobei
zwischen dem Leiter (27) und der Magnetbahn (3) eine weitere Komponente angeordnet ist oder ein Spalt dazwischen gebildet ist.

7. Speichervorrichtung (100) nach Anspruch 6, wobei
ein Plattenelement (4), welches aus einem nicht-magnetischen Material hergestellt ist, zwischen dem Leiter (27) und der Magnetbahn (3) angeordnet ist.

8. Speichervorrichtung (100) nach einem der Ansprüche 1 bis 7, umfassend:
wenigstens zwei Leistungsaufnahmeeinheiten (34), welche in einer Umfangsrichtung um die rotierende Welle (15) herum angeordnet sind, wobei
die Leistungsübertragungseinheit (14) derart angeordnet ist, dass sie einer Rotationsspur der Leistungsaufnahmeeinheiten (34) zugewandt ist, und
bei Betrachtung in einer Richtung parallel zu der rotierenden Welle (15), die Leistungsübertragungseinheit (14) in einer Kreisbogenform gebildet ist, welche eine Öffnung (14a) aufweist, welche sich entlang einer Umfangsrichtung der rotierenden Welle (15) erstreckt, wobei die Leistungsübertragungseinheit (14) derart angeordnet ist, dass sie immer mit wenigstens einer der Leistungsaufnahmeeinheiten (34) überlappt.

9. Speichervorrichtung (100) nach Anspruch 8, wobei
die Öffnung (14a) in einer Größe gebildet ist, welche es ermöglicht, die rotierende Welle dorthindurch passieren zu lassen, und
die Leistungsübertragungseinheit (14) abnehmbar an einer äußeren Umfangsseite der rotierenden Welle (15) montiert ist.

10. Speichervorrichtung (100) nach einem der Ansprüche 1 bis 9, wobei
die leistungsgetriebene Vorrichtung (33) wenigstens eines aus einem Temperatursensor, einem Feuchtigkeitssensor, einem Gaskomponentendetektor und einer Kamera umfasst.

## Revendications

1. Appareil de stockage (100) qui stocke des objets, comprenant :
un logement (1) ;
un socle de base (11) qui est disposé dans le logement (1), sa position étant fixe contre le logement (1) ;
une tablette de stockage rotative (31) qui est raccordée au socle de base (11) par le biais d'un arbre rotatif (15) s'étendant dans la direction verticale et rotative par rapport au socle de base (11), le socle de rotation étant l'arbre rotatif (15), la tablette de stockage rotative (31) comprenant une tablette rotative (32) sur laquelle des objets sont disposés ; et
une partie d'entraînement d'arbre rotatif (81) qui fait tourner l'arbre rotatif (15) ;
dans lequel
le socle de base (11) comprend une unité de transmission de puissance (14) qui transmet une puissance électrique dans un état de non-contact entre le socle de base (11) et la tablette de stockage (31) ; et
la tablette de stockage (31) rotative comprend :
un dispositif à puissance motrice (33) ou un dispositif de détection (33), le dispositif étant disposé de manière à tourner d'un seul tenant avec la tablette rotative (32) et le dispositif étant entraîné par une puissance électrique ; et
une unité de réception de puissance (34) qui fournit la puissance électrique transmise à partir de l'unité de transmission de puissance (14) au dispositif à puissance motrice (33) ou au dispositif de détection (33).

2. Appareil de stockage (100) selon la revendication 1, dans lequel
l'unité de transmission de puissance (14) comporte :
un support (22) qui entoure au moins une partie de la circonférence externe de l'arbre rotatif (15), et
un conducteur (27) disposé sur le support (22) le long de la direction dans laquelle le support (22) s'étend,
dans lequel l'unité de réception de puissance (34) comprend une bobine (43) formée par enroulement d'un composant de conducteur (47), et
lorsqu'un champ magnétique est généré par un courant circulant à travers le conducteur (27) de l'unité de transmission de puissance (14), un courant induit est généré dans la bobine (43) de l'unité de réception de puissance (34).

3. Appareil de stockage (100) selon la revendication 2, dans lequel
le conducteur (27) est fourni par un motif de circuit (29) d'une carte de circuit imprimé (28).

4. Appareil de stockage (100) selon la revendication 2, dans lequel
le support (22) présente une partie de guidage de conducteur (25) formée pour s'étendre dans la direction circonférentielle, et
le conducteur (27) est disposé le long de la partie de guidage de conducteur (25).

5. Appareil de stockage (100) selon l'une quelconque des revendications 2 à 4, dans lequel
l'unité de transmission de puissance (14) présente une feuille magnétique (3) disposée sur un côté opposé à un côté où le conducteur (27) et l'unité de réception de puissance (34) se font face.

6. Appareil de stockage (100) selon la revendication 5, dans lequel
un autre composant est disposé ou un espace est formé entre le conducteur (27) et la feuille magnétique (3).

7. Appareil de stockage (100) selon la revendication 6, dans lequel
un élément de plaque (4) composé d'un matériau non magnétique est disposé entre le conducteur (27) et la feuille magnétique (3).

8. Appareil de stockage (100) selon l'une quelconque des revendications 1 à 7, comprenant :
au moins deux unités de réception de puissance (34) disposées dans une direction circonférentielle autour de l'arbre rotatif (15), dans lequel
l'unité de transmission de puissance (14) est disposée pour faire face à une piste de rotation des unités de réception de puissance (34), et
lorsqu'elle est vue dans une direction parallèle à l'arbre rotatif (15), l'unité de transmission de puissance (14) présente une forme d'arc de cercle présentant une ouverture (14a) qui s'étend le long d'une direction circonférentielle de l'arbre rotatif (15), dans lequel l'unité de transmission de puissance (14) est disposée pour toujours chevaucher au moins l'une des unités de réception de puissance (34).

9. Appareil de stockage (100) selon la revendication 8, dans lequel
l'ouverture (14a) présente une taille qui permet de faire passer l'arbre rotatif (15) au travers, et
l'unité de transmission de puissance (14) est montée de manière amovible sur un côté circonférentiel externe de l'arbre rotatif (15).

10. Appareil de stockage (100) selon l'une quelconque des revendications 1 à 9, dans lequel
le dispositif à puissance motrice (33) comporte au moins un d'un capteur de température, d'un capteur d'humidité, d'un détecteur de composant de gaz et d'une caméra.
